(19) Europäisches Patentamt
European Patent Office
Office européen des brevets

(11) **EP 3 853 774 B1**

(12) **FASCICULE DE BREVET EUROPEEN**

(45) Date de publication et mention
de la délivrance du brevet:
**12.07.2023 Bulletin 2023/28**

(21) Numéro de dépôt: **19766037.6**

(22) Date de dépôt: **16.09.2019**

(51) Classification Internationale des Brevets (IPC):
**G06K 19/077** [(2006.01)]

(52) Classification Coopérative des Brevets (CPC):
(C-Sets disponibles)
**G06K 19/07756;** H01L 2224/48095;
H01L 2224/73265; H01L 2924/181          (Cont.)

(86) Numéro de dépôt international:
**PCT/EP2019/074608**

(87) Numéro de publication internationale:
**WO 2020/058149 (26.03.2020 Gazette 2020/13)**

(54) **PROCEDE DE CONNEXION D'UN CIRCUIT INTEGRE A UN CIRCUIT ELECTRIQUE**

VERFAHREN ZUM VERBINDEN EINER INTEGRIERTEN SCHALTUNG MIT EINER ELEKTRISCHEN SCHALTUNG

METHOD FOR CONNECTING AN INTEGRATED CIRCUIT TO AN ELECTRICAL CIRCUIT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **18.09.2018 FR 1858420**

(43) Date de publication de la demande:
**28.07.2021 Bulletin 2021/30**

(73) Titulaire: **Smart Packaging Solutions (SPS)
13790 Rousset (FR)**

(72) Inventeurs:
• **DANLER BAUMGARTNER, Stephan
13790 ROUSSET (FR)**
• **GERIN, Guillaume
13790 ROUSSET (FR)**
• **MEAR, Benjamin
13790 ROUSSET (FR)**

(74) Mandataire: **Nicolle, Olivier
Ipon Global
29, boulevard Georges Seurat
92200 Neuilly-sur-Seine (FR)**

(56) Documents cités:
**FR-A1- 2 780 848    FR-A1- 2 905 494**

(52) Classification Coopérative des Brevets (CPC):
(Cont.)

C-Sets
H01L 2924/181, H01L 2924/00012

## Description

L'invention concerne un procédé de connexion d'un circuit intégré destiné à être connecté à un circuit électrique et un objet dual (portatif sans contact et avec contact). Elle concerne notamment la connexion d'une puce électronique à un circuit électrique comprenant une antenne.

L'invention peut s'appliquer pour des cartes sans contact, des cartes « dual », ayant une fonction sans contact et une fonction avec contact pouvant être utilisées dans le domaine bancaire, pour le commerce, pour des objets utilisés pour de l'identification, par exemple des étiquettes RFID (Radio Frequency Identification), etc.

Elle s'applique à tout objet comprenant au moins une fonction de transaction sans contact et comprenant un circuit intégré.

Les objets portatifs sans contact comportent d'une part, un circuit intégré et, d'autre part, un circuit conducteur d'antenne. Les bornes du circuit d'antenne sont connectées au circuit intégré pour l'émission et la réception de signaux radiofréquence entre un lecteur distant et ledit circuit intégré.

La connexion des plages de contact du circuit intégré aux bornes d'un circuit conducteur d'antenne peut être réalisée selon différentes technologies. Il faut tout d'abord connecter les plages de contact à des plages de contact disposées sur un substrat. Pour se faire, on utilise la technologie de connexion par fils plus connue sous la dénomination anglo-saxonne de « wire bonding » ou une technologie qui retourne la puce, le « flip chip ».

Le circuit intégré est ensuite connecté au circuit d'antenne. Pour cela différentes technologies sont possibles : en utilisant une méthode de connexion par protubérance connue dans la littérature sous le terme anglo-saxon de « bump »,

- avec un film adhésif conducteur anisotropique ou ACF, ou
- en couplage inductif.

Le brevet FR 2894714 décrit un procédé permettant de connecter une puce électronique à des plots de connexion d'un circuit électrique. La puce comporte deux plages de contact situées au niveau de la dernière couche constitutive de la puce qui permettent un couplage capacitif avec les bornes de contact de l'antenne. Ce procédé implique une modification des dessins dans la fabrication de la puce. De plus, l'usage quasi-exclusif de la dernière couche de la puce pour positionner des plages de contact empêche d'exploiter l'ensemble de ses capacités.

La demande de brevet WO2009/115673 divulgue un objet sans contact comprenant un circuit intégré connecté aux bornes d'un circuit électrique par couplage capacitif. Le circuit intégré comporte au niveau de sa face active une première couche diélectrique formant une couche de passivation et des plages de contact affleurant au travers d'ouvertures de la couche de passivation. Le circuit intégré comprend des plaques de connexion connectées aux bornes du circuit, permettant ainsi un couplage capacitif. Les plaques de contact qui réalisent le couplage capacitif sont positionnées à la surface de la couche de passivation. Ceci entraîne un post-traitement des circuits intégrés.

La demande de brevet français FR2905494A1 décrit un module sans contact comprenant un circuit intégré et une antenne connectée entre eux par couplage capacitif d'armatures métalliques. Le module comprenant en outre un corps présentant des butées d'espacement qui délimitent l'écarement des armatures de condensateur des connexions électriques capacitives. L'inconvénient de cette solution est que la réduction de l'espacement entre les armatures est limité par l'utilisation des butées d'espacement.

La demande de brevet français FR2780848 A1 décrit antenne pour carte à circuit intégré, comprenant une piste conductrice formant au moins une spire et ayant des extrémités comprenant des couches conductrices formant des bornes de connexion.

L'invention propose une nouvelle approche pour réaliser un objet ayant une fonction sans contact et avec contact. L'idée consiste à ne pas modifier le circuit intégré (ou puce électronique) et à positionner des plaques de contact réalisant le couplage capacitif au niveau d'un module, sur une face qui est en regard d'une surface de l'objet sans contact.

L'invention concerne un objet portatif selon la revendication 1.

Ladite antenne et la deuxième plaque conductrice peuvent être disposées entre deux couches de plastique et le substrat peut comporter des plots ISO sur une face opposée à la face recevant la première plaque conductrice.

L'objet portatif peut être une carte comprenant une fonction de transaction sans contact et une fonction de transaction avec contact, ou une carte bancaire avec au moins une fonction sans contact.

L'invention concerne aussi un procédé selon la revendication 4.

Selon une variante de réalisation, le circuit intégré utilisé dans le procédé est une puce électronique et or dispose en regard de la puce électronique et de l'antenne:

- Au moins deux premières plaques conductrices sur la surface du substrat de la puce, les deux premières plaques entourant la puce, la puce étant connectée aux premières plaques conductrices via des liaisons, et
- Au moins deux deuxième plaques conductrices au niveau d'un corps de carte portant l'antenne, lesdites deux deuxièmes plaques conductrices étant en liaison électrique à une première extrémité de l'antenne et à une deuxième extrémité de l'antenne,

• Lesdites premières plaques conductrices sur le substrat et lesdites deuxièmes plaques conductrices sur un te- corps d'antenne présentant des caractéristiques électriques et géométriques adaptées pour réaliser un couplage capacitif entre le circuit intégré et l'antenne.

Les deuxièmes plaques conductrices peuvent être disposées sur un support en PVC ou au niveau d'un support en PVC.

Selon un mode de réalisation, la puce est connectée à des contacts ISO disposés sur une face du substrat opposée à la face du substrat recevant les premières plaques conductrices.

D'autres caractéristiques et avantages de la présente invention apparaîtront mieux à la lecture de la description donnée à titre illustratif et nullement limitatif, d'exemples de réalisation annexée des figures qui représentent :

• Figure 1, une illustration du schéma électrique du procédé selon l'invention,
• Figure 2A, une vue de face d'un module selon l'invention, Figure 2B, une variante dans la forme des zones métalliques,
• Figure 3, une vue en coupe du module,
• Figure 4A, une vue de face d'une antenne non comprise dans l'invention revendiquée, Figure 4B, un deuxième exemple d'antenne avec un coût de revient plus faible,
• Figure 5, une vue éclatée de la carte sans contact comprenant des éléments des figures 2-4A, et
• Figure 6 une vue de coupe d'une carte de la figure 5.

Afin de mieux faire comprendre l'invention, l'exemple qui suit est donné pour la fabrication d'une carte utilisée par exemple pour une transation sans contact. Il est bien entendu que la description qui va suivre peut aussi être utilisée pour la fabrication d'étiquettes RFID ou encore de carte dual (comprenant une fonction sans contact et avec contact), dans le domaine de l'identité. Ces exemples sont listés à titre d'exemples non limitatifs.

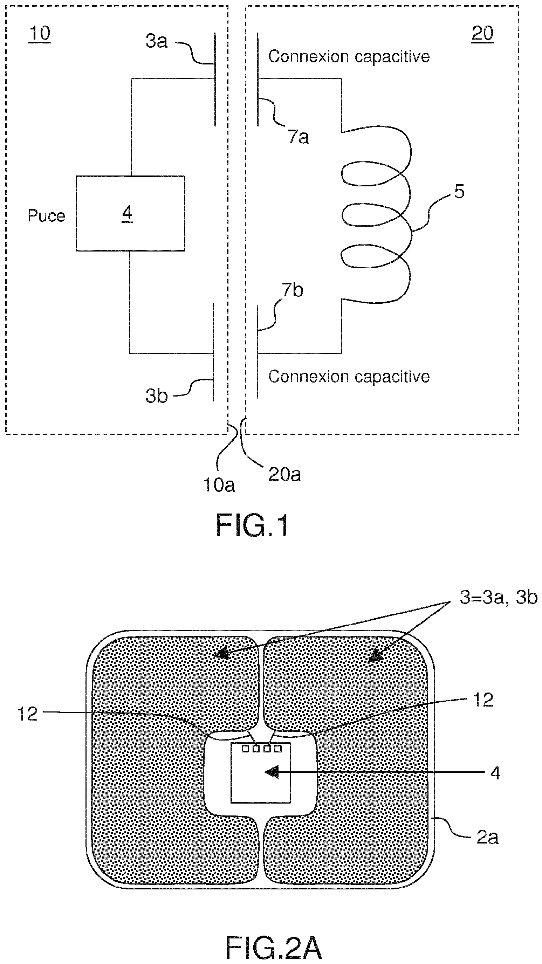

La figure 1 est un schéma électrique illustrant le principe de connexion selon l'invention d'une puce (circuit intégré) avec un circuit électrique comprenant une antenne. Le module 10 comprend un circuit intégré (puce) 4 connecté à au moins une plaque ou surface conductrice 3a, 3b, déposée sur une surface du substrat du film 2 ou du module. Le circuit électrique ou antenne 5 est déposé sur un support 20 et est connecté à au moins une surface conductrice 7a, 7b. La deuxième surface conductrice 7a, 7b est disposée sur une des faces du support 20, la face 20a opposée à la face 10a du module 10. Les deux surfaces conductrices 3a et 7a sont disposées en regard l'une de l'autre. Il en est de même pour les deux surfaces 3b et 7b. La dimension de la surface conductrice formant l'antenne au niveau du corps de carte aura, par exemple, des dimensions supérieures afin d'absorber les décalages potentiels en XY du module par rapport à l'antenne du corps de carte. Dans l'exemple de la figure 1, pour des raisons de fabrication, la surface conductrice est composée de deux éléments 3a, 3b en forme de U qui viennent entourer la puce. La surface conductrice présente la même forme de U, 7a, 7b.

Sans sortir du cadre de l'invention, il serait aussi possible de former les surfaces conductrices en une seule partie, deux éléments conducteurs 3a, 3b et deux éléments conducteurs 7a, 7b.

Les valeurs de capacité sont données par la formule :

$$C = \frac{\varepsilon_0 * \varepsilon_r * S}{Epaisseur}$$

Avec :

$$\varepsilon = \varepsilon_0 \times \varepsilon_r$$

• $\varepsilon$ la permittivité du matériau se situant entre les surfaces de métal en regard,
• $\varepsilon_0$ la permittivité du vide,
• $\varepsilon_r$ la permittivité relative du matériau se situant entre les surfaces de métal en regard,
• $\varepsilon_0$ est une constante physique qui vaut : 8,85418782 $\times$ 10$^{-12}$ m$^{-3}$ kg$^{-1}$ s$^4$ S$^2$,
• $S$ : surface des deux plaques conductrices de métal qui sont en regard l'une de l'autre et seulement en regard. On considère l'intersection des deux surfaces dans un plan (x, y), l'épaisseur correspond à la distance entre les deux plaques conductrices.

Pour une géométrie de capacité donnée, c'est-à-dire surface de métal et distance entre les plaques, la valeur de capacité exprimée en Farad sera d'autant plus grande que la valeur de permittivité relative $\varepsilon_r$ du matériau se situant entre les deux surfaces de métal en regard.

Dans le cas d'une carte en PVC, sa permittivité relative de 5 donne une valeur de capacité cinq fois plus grande que si le PVC était remplacé par de l'air, dont la permittivité relative est égale à 1.

Plus la valeur de capacité est élevée, plus les performances de la carte seront élevées. L'utilisation du PVC, en minimisant l'épaisseur et en maximisant les surfaces de métal en regards permettra d'obtenir un bon couplage capacitif.

L'épaisseur sera choisie la plus fine possible.

Selon un mode de réalisation, lors de l'encartage on utilise uniquement l'épaisseur de l'adhésif d'encartage pour adapter la distance entre les plaques conductrices 7a, 7b. Pour cela, on ne crée pas de butée comme dans les procédés de l'art antérieur, mais on met à nu les plaques ou surfaces conductrices en usinant un emplacement au milieu de celles-ci. Ceci permet d'absorber les tolérances d'usinage dans un axe perpendiculaire à la surface du module. Ceci permet aussi d'avoir une épaisseur entre les plaques conductrices indépendantes de l'usinage et plus fine que l'épaisseur habituelle des modules de l'art antérieur, car égale à l'épaisseur de l'adhésif comprise entre 10 et 30μm. Au niveau de la zone d'usinage, l'épaisseur de l'antenne intégrée dans le corps de carte est de préférence supérieure à 70μm pour réaliser cette variante. Les valeurs de capacité atteignables sont alors de l'ordre de deux fois 70pF pour un format de module d'environ 11.8mm x 13mm pouvant accueillir 8 contacts ISO-7816.

Pour une carte dual, l'antenne est dans la fibre neutre de la carte et le module à la surface. L'usinage de la carte dans lequel le module sera positionné a pour but de rapprocher au maximum les surfaces de métal de l'antenne du corps de carte aux surfaces de métal présentes au dos du module. Suivant la précision de l'usinage en question, l'épaisseur entre les surfaces de métal peut varier de 0 à 100μm. Dans le cas de la carte dual avec un module dual 6, l'objectif est d'obtenir au moins deux fois 10pF, afin d'avoir un fonctionnement capacitif correct. Dans ce cas, les surfaces disponibles sur le module sont de l'ordre de deux fois 45mm$^2$ (deux fois 73mm$^2$ dans le cadre du dual 8).

Ces valeurs sont données à titre d'exemples non limitatifs, les dimensions et le matériau formant les surfaces métalliques seront notamment choisis en fonction de l'application de l'objet portatif.

Les technologies de dépôt des surfaces ou plaques conductrices sont connues de l'homme du métier et ne seront pas détaillées.

La figure 2A est une vue de face d'un module 10 selon l'invention. Le circuit intégré 4, par exemple une puce, est connecté via des moyens électriques 12 connus de l'homme du métier aux deux surfaces conductrices 3a, 3b en forme de U. Les deux surfaces, plaques, conductrices sont disposées sur une face 2a du substrat 2. Le module est, par exemple, un substrat composé d'un diélectrique en sandwich avec deux couches conductrices qui sont ensuite gravées.

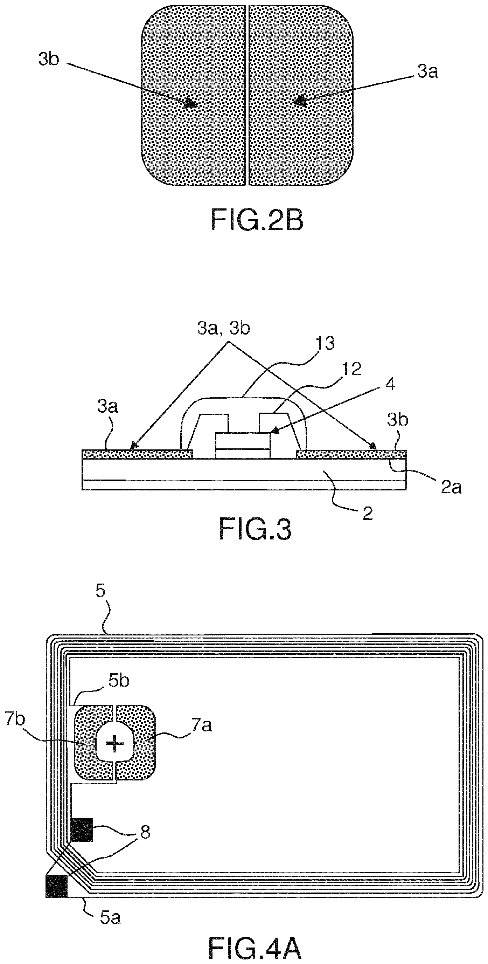

La figure 2B illustre un autre exemple de forme de surfaces conductrices.

La figure 3 est une vue de coupe du module comportant une résine de protection 13 englobant le circuit intégré 4. Les éléments référencés sont identiques à ceux des figures 1 et 2A.

La figure 4A est une vue de face d'un exemple d'antenne 5 non comprise dans l'invention revendiquée. L'antenne 5 se présente sous la forme d'une piste conductrice constituant plusieurs spires. Une première extrémité 5a de la piste en aluminium par exemple, est connectée à un premier plot de connexion 8, qui est connecté lui-même à une première partie 7a de la surface conductrice. La deuxième extrémité de la piste 5b est connectée à une deuxième partie 7b de la surface conductrice. Les plots de connexion 8 servent notamment de pont ou « strap » pour que la fin de l'antenne rentre au voisinage de son point de départ. Une première extrémité de l'antenne va revenir vers sa deuxième extrémité.

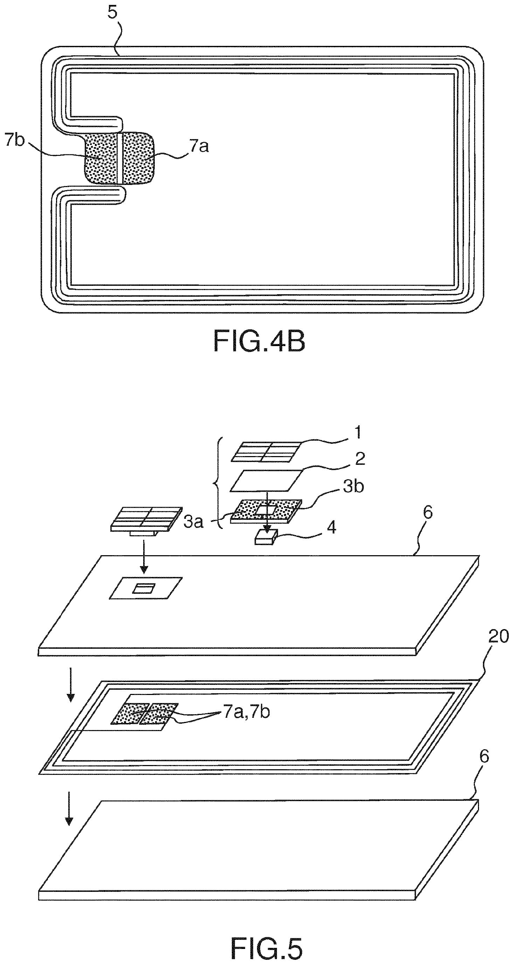

La figure 4B, illustre une vue de face de l'antenne simple face comprenant plusieurs pistes métalliques sous forme de spires 5 connectée aux deux surfaces conductrices 7a, 7b. Une première extrémité 5a de l'antenne est connectée à une première partie 7a de la deuxième plaque conductrice et une deuxième extrémité 5b de l'antenne est connectée à une deuxième partie 7b de la deuxième plaque conductrice, les pistes d'antenne passent entre les contacts 7a et b évitant ainsi la présence d'un pont.

L'antenne peut être réalisée sur un support souple ou rigide selon des technologies connues de l'homme du métier.

La figure 5 est une vue éclatée d'une carte sans contact comprenant un module.

On retrouve les éléments des figures précédentes 2 à 4A.

Le module 10 comprend des contacts ISO 1, par exemple, disposés sur une face 2b du substrat 2, opposée à la face du substrat recevant les plaques ou surfaces conductrices 3a, 3b. La puce 4 est par exemple positionnée sur le substrat au moyen d'une colle adhésive.

Le circuit antenne 5, ainsi que les plaques conductrices 7a, 7b positionnées en regard des plaques conductrices 3a, 3b afin de former un couplage capacitif sont disposés entre deux couches de plastique 6 selon une technologie de fabrication connue de l'homme du métier.

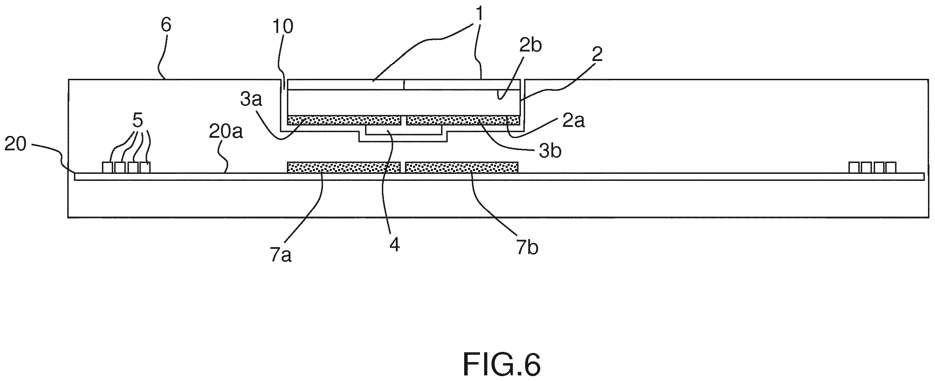

La figure 6 représente une coupe de la carte sans contact représentée à la figure 5.

Le procédé de connexion et le module obtenu par sa mise en oeuvre permettent avantageusement d'utiliser des circuits électroniques standard sans nécessiter d'adapter la technologie de fabrication de ces puces. Les coûts de fabrication des objets sans contacts sont ainsi diminués.

Les plaques conductrices étant disposées au niveau du substrat, elles permettent de diminuer les capacités parasites avec le circuit intégré.

Le mode d'insertion du module dans la carte se fait de manière traditionnelle, en utilisant les mêmes encarteuses que pour les cartes contacts, étant donné qu'il n'y a pas de soudure à effectuer entre le module et l'antenne.

Le module est moins coûteux que celui utilisé en technologie de couplage inductif car il ne nécessite pas une grande résolution pour l'antenne module (il n'y en a pas) et ne comporte nécessairement de via sur le module.

La durée de vie de la carte pourra être bien supérieure à celle obtenue par d'autres technologies, car il n'y a pas de connexion physique entre la carte et le module et une antenne simple sur le corps de carte est plus robuste qu'une antenne double face utilisée notamment en couplage inductif.

## Revendications

**1.** - Objet portatif ayant une fonction sans contact ou une fonction duale sans contact et avec contact, comprenant un circuit intégré (4), un substrat (2) et un circuit électrique (5), et au moins les éléments suivants :

  • Au moins une première plaque conductrice (3a, 3b) de géométrie et de dimensions données, positionnée sur au moins une partie d'une face (2a) du substrat (2),
  • Ledit au moins un circuit intégré (4) relié à la première plaque conductrice au moyen de connexions (12),
  • Au moins une deuxième plaque conductrice (7a, 7b) de géométrie et de dimensions données, positionnée au niveau d'une couche comprenant le circuit électrique (5), et reliée au circuit électrique,
  • Les dimensions de la première plaque conductrice (3a, 3b) et de la deuxième plaque conductrice (7a, 7b) disposées en regard l'une de l'autre et la distance les séparant sont adaptées à réaliser un couplage électrique de type capacitif, ladite distance de séparation étant égale à l'épaisseur d'un adhésif utilisé pour l'encartage de la carte
  • Le circuit électrique (5) est une antenne simple face comprenant plusieurs pistes, une première extrémité (5a) de l'antenne est connectée à une première partie (7a) de la deuxième plaque conductrice et une deuxième extrémité de l'antenne (5b) est connectée à une deuxième partie (7b) de la deuxième plaque conductrice, **caractérisé en ce que** les pistes de l'antenne passent entre les première et deuxième parties (7a,7b) de la deuxième plaque conductrice, et ladite distance de séparation est supérieure ou égale à 10μm et inférieure à 30μm.

**2.** - Objet portatif selon la revendication 1 **caractérisé en ce que** ladite antenne (5) et la deuxième plaque conductrice (7a, 7b) sont disposées entre deux couches de plastique (6) et **en ce que** le substrat (2) comporte des plots ISO sur une face opposée (2b) à la face (2a) recevant la première plaque conductrice (3a, 3b).

**3.** - Objet portatif selon l'une des revendications 1 ou 2 **caractérisé en ce qu'**il est formé d'une carte comprenant une fonction de transaction sans contact et d'une fonction de transaction avec contact.

**4.** - Procédé de connexion d'un circuit intégré (4) disposé sur un substrat à une antenne (5) présent dans un objet portatif ayant une fonction sans contact ou une fonction duale sans contact et avec contact, le procédé comportant au moins les étapes suivantes :

  • Utiliser au moins une première plaque conductrice (3a, 3b) sur une surface (2a) du substrat (2) sur lequel est connecté ledit circuit intégré (4),
  • Utiliser au moins une deuxième plaque conductrice (7a, 7b) sur un support (20) contenant l'antenne simple face (5) comprenant plusieurs pistes, une première extrémité (5a) de l'antenne est connectée à une première partie (7a) de la deuxième plaque conductrice et une deuxième extrémité de l'antenne (5b) est connectée à une deuxième partie (7b) de la deuxième plaque conductrice,
  • La première plaque conductrice (3a, 3b) et la deuxième plaque conductrice (7a, 7b) sont disposées en regard l'une de l'autre, leurs caractéristiques géométriques et électriques, et la distance de séparation entre les deux plaques conductrices, sont adaptées pour réaliser un couplage capacitif entre le circuit intégré et l'antenne, ladite distance de séparation étant égale à l'épaisseur d'un adhésif utilisé pour l'encartage de la carte, **caractérisé en ce que** ladite distance de séparation est supérieure ou égale à 10μm et inférieure à 30μm, et les pistes de l'antenne passent entre les première et deuxième parties (7a,7b) de la deuxième plaque conductrice.

**5.** - Procédé selon la revendication 4 dans lequel le circuit intégré (4) est une puce électronique et en ce qu'on dispose en regard de la puce électronique et de l'antenne (5):

  • Au moins deux premières plaques conductrices (3a, 3b) sur la surface (2a) du substrat (2) de la puce (4), les deux premières plaques conductrices (3a, 3b) entourant la puce (4), la puce (4) étant connectée aux premières plaques conductrices (3a, 3b) via des liaisons (12), et
  • Au moins deux deuxième plaques conductrices (7a, 7b) au niveau d'un corps de carte portant l'antenne (5), lesdites deux deuxième plaques conductrices (7a, 7b) étant en liaison électrique à une première extrémité (5a) de l'antenne et à une deuxième extrémité (5b) de l'antenne,
  • Lesdites premières plaques conductrices sur le substrat et lesdits deuxièmes plaques conductrices sur un corps d'antenne présentant des caractéristiques électriques et géométriques adaptées pour réaliser un couplage capacitif entre le circuit intégré et l'antenne.

**6.** - Procédé selon l'une des revendications 5 ou 6 **caractérisé en ce que** les deuxièmes plaques conductrices (7a, 7b) sont disposées sur ou au niveau d'un support en PVC.

7. - Procédé de connexion d'une puce avec une antenne selon la revendication 5 **caractérisé en ce que** la puce est connectée à des contacts ISO disposés sur une face du substrat (2) opposée à la face du substrat recevant les premières plaques conductrices (3).

**Patentansprüche**

1. - Tragbarer Gegenstand mit einer kontaktlosen Funktion oder einer dualen kontaktlosen und kontaktbasierten Funktion, der einen integrierten Schaltkreis (4), ein Substrat (2) und einen Stromkreis (5) sowie mindestens die folgenden Elemente umfasst:

   • mindestens eine erste leitfähige Platte (3a, 3b) mit vorgegebener Geometrie und Größe, die auf mindestens einem Teil einer Seite (2a) des Substrats (2) positioniert ist,
   • den mindestens einen integrierten Schaltkreis (4), der mittels Verbindungen (12) mit der ersten leitfähigen Platte verbunden ist,
   • mindestens eine zweite leitfähige Platte (7a, 7b) mit vorgegebener Geometrie und Größe, die an einer Schicht positioniert ist, die den Stromkreis (5) umfasst, und die mit dem Stromkreis verbunden ist,
   • Die Abmessungen der ersten leitfähigen Platte (3a, 3b) und der zweiten leitfähigen Platte (7a, 7b), die einander gegenüberliegend angeordnet sind, und der Abstand, der sie voneinander trennt, sind so angepasst, dass eine elektrische Kopplung vom kapazitiven Typ erfolgen kann, wobei der Trennungsabstand gleich der Dicke eines zum Einlegen der Karte verwendeten Klebstoffs ist,
   • Der Stromkreis (5) ist eine einseitige Antenne mit mehreren Leiterbahnen, wobei ein erstes Ende (5a) der Antenne mit einem ersten Teil (7a) der zweiten leitfähigen Platte und ein zweites Ende der Antenne (5b) mit einem zweiten Teil (7b) der zweiten leitfähigen Platte verbunden ist, **dadurch gekennzeichnet, dass** die Leiterbahnen der Antenne zwischen dem ersten und zweiten Teil (7a, 7b) der zweiten leitfähigen Platte verlaufen und der Trennungsabstand größer oder gleich 10 $\mu$m und kleiner als 30 $\mu$m ist.

2. - Tragbarer Gegenstand nach Anspruch 1, **dadurch gekennzeichnet, dass** die Antenne (5) und die zweite leitfähige Platte (7a, 7b) zwischen zwei Kunststoffschichten (6) angeordnet sind und das Substrat (2) auf einer Seite (2b) gegenüber der Seite (2a), welche die erste leitfähige Platte (3a, 3b) aufnimmt, ISO-Kontakte umfasst.

3. - Tragbarer Gegenstand nach einem der Ansprüche 1 oder 2, **dadurch gekennzeichnet, dass** er aus einer Karte mit einer kontaktlosen Transaktionsfunktion und einer kontaktbasierten Transaktionsfunktion gebildet wird.

4. - Verfahren zum Verbinden eines auf einem Substrat angeordneten integrierten Schaltkreises (4) mit einer Antenne (5), die sich in einem tragbaren Gegenstand mit einer kontaktlosen Funktion oder einer dualen kontaktlosen und kontaktbasierten Funktion befindet, wobei das Verfahren mindestens die folgenden Schritte umfasst:

   • die Verwendung von mindestens einer ersten leitfähigen Platte (3a, 3b) auf einer Oberfläche (2a) des Substrats (2), mit der der integrierte Schaltkreis(4) verbunden ist,
   • die Verwendung von mindestens einer zweiten leitfähigen Platte (7a, 7b) auf einem Träger (20), der die einseitige Antenne (5) mit mehreren Leiterbahnen enthält, wobei ein erstes Ende (5a) der Antenne mit einem ersten Teil (7a) der zweiten leitfähigen Platte und ein zweites Ende der Antenne (5b) mit einem zweiten Teil (7b) der zweiten leitfähigen Platte verbunden ist,
   • Die erste leitfähige Platte (3a, 3b) und die zweite leitfähige Platte (7a, 7b) sind einander gegenüberliegend angeordnet, wobei ihre geometrischen und elektrischen Eigenschaften und der Trennungsabstand zwischen den beiden leitfähigen Platten so angepasst sind, dass eine kapazitive Kopplung zwischen dem integrierten Schaltkreis und der Antenne erfolgen kann, wobei der Trennungsabstand gleich der Dicke eines Klebstoffs ist, der zum Einlegen der Karte verwendet wird, **dadurch gekennzeichnet, dass** der Trennungsabstand größer oder gleich 10 $\mu$m und kleiner als 30 $\mu$m ist und die Leiterbahnen der Antenne zwischen dem ersten und dem zweiten Teil (7a, 7b) der zweiten leitfähigen Platte verlaufen.

5. - Verfahren nach Anspruch 4, bei dem der integrierte Schaltkreis (4) ein Mikrochip ist und gegenüber dem Mikrochip und der Antenne (5) folgendes anordnet ist:

   • mindestens zwei erste leitfähige Platten (3a, 3b) auf der Oberfläche (2a) des Substrats (2) des Chips (4), wobei die beiden ersten leitfähigen Platten (3a, 3b) den Chip (4) umgeben und der Chip (4) mit den ersten leitfähigen Platten (3a, 3b) über Verbindungen (12) verbunden ist, und
   • mindestens zwei zweite leitfähige Platten (7a, 7b) an einem Kartenkörper, der die Antenne (5) trägt, wobei die zwei zweiten leitfähigen Platten (7a, 7b) mit einem ersten Ende (5a) der Antenne und einem zweiten Ende (5b) der Antenne elektrisch verbunden sind,

• Die ersten leitfähigen Platten auf dem Substrat und die zweiten leitfähigen Platten auf einem Antennenkörper weisen elektrische und geometrische Eigenschaften auf, die so angepasst sind, dass eine kapazitive Kopplung zwischen dem integrierten Schaltkreis und der Antenne erfolgen kann.

**6.** - Verfahren nach einem der Ansprüche 5 oder 6, **dadurch gekennzeichnet, dass** die zweiten leitfähigen Platten (7a, 7b) auf oder an einem PVC-Träger angeordnet sind.

**7.** - Verfahren zum Verbinden eines Chips mit einer Antenne nach Anspruch 5, **dadurch gekennzeichnet, dass** der Chip mit ISO-Kontakten verbunden ist, die auf einer Seite des Substrats (2) gegenüber der Substratseite angeordnet sind, die die ersten leitfähigen Platten (3) aufnimmt.

**Claims**

**1.** - A portable object having a contactless function or a dual contactless and contact function, comprising an integrated circuit (4), a substrate (2) and an electrical circuit (5), as well as at least the following elements:

• At least a first conductive plate (3a, 3b) of a given shape and dimensions, positioned on at least a portion of a side (2a) of the substrate (2),
• Said at least one integrated circuit (4) connected to the first conductive plate by means of connections (12),
• At least a second conductive plate (7a, 7b) of a given shape and dimensions, positioned on a layer comprising the electrical circuit (5) and connected to the electrical circuit,
• The dimensions of the first conductive plate (3a, 3b) and of the second conductive plate (7a, 7b) arranged opposite each other and the distance between them are suitable for establishing an electric coupling of a capacitive type, said separation distance being equal to the thickness of an adhesive used for embedding the card,
• The electrical circuit (5) is a single-sided antenna comprising several tracks, wherein a first end (5a) of the antenna is connected to a first portion (7a) of the second conductive plate and a second end of the antenna (5b) is connected to a second portion (7b) of the second conductive plate, **characterised in that** the tracks of the antenna pass between the first and second portions (7a, 7b) of the second conductive plate, and said separation distance is greater than or equal to $10\mu$m and less than $30\mu$m.

**2.** - The portable object according to claim 1, **characterised in that** said antenna (5) and the second conductive plate (7a, 7b) are arranged between two layers of plastic (6) and **in that** the substrate (2) comprises ISO pads on a side (2b) opposite to the side (2a) receiving the first conductive plate (3a, 3b).

**3.** - The portable object according to either of claims 1 or 2, **characterised in that** it is formed of a card comprising a contactless transaction function and a contact transaction function.

**4.** - A method of connecting an integrated circuit (4) arranged on a substrate to an antenna (5) present in a portable object having a contactless function or a dual contactless and contact function, wherein the method comprises at least the following steps:

• Use of at least a first conductive plate (3a, 3b) on a surface (2a) of the substrate (2) to which said integrated circuit (4) is connected,
• Use of at least one second conductive plate (7a, 7b) on a support (20) containing the single-sided antenna (5) comprising several tracks, wherein a first end (5a) of the antenna is connected to a first portion (7ût) of the second conductive plate and a second end of the antenna (5b) is connected to a second portion (7b) of the second conductive plate,
• The first conductive plate (3a, 3b) and the second conductive plate (7a, 7b) are arranged opposite each other, their geometric and electrical characteristics, and the separation distance between the two conductive plates are suitable for achieving capacitive coupling between the integrated circuit and the antenna, said separation distance being equal to the thickness of an adhesive used for embedding the card, **characterised in that** said separation distance is greater than or equal to $10\mu$m and less than 30pm, and the tracks of the antenna pass between the first and second portions (7a, 7b) of the second conductive plate.

**5.** - The method according to claim 4, wherein the integrated circuit (4) is an electronic chip and wherein the following elements are arranged opposite the electronic chip and the antenna (5):

• At least two first conductive plates (3a, 3b) on the surface (2a) of the substrate (2) of the chip (4), wherein the two first conductive plates (3a, 3b) surround the chip (4), the chip (4) being connected to the first conductive plates (3a, 3b) via links (12), and

• At least two second conductive plates (7a, 7b) on a card body bearing the antenna (5), said two second conductive plates (7a, 7b) being electrically connected to a first end (5a) of the antenna and a second end (5b) of the antenna,

• Said first conductive plates on the substrate and said second conductive plates on an antenna body having electrical and geometrical characteristics suitable for establishing a capacitive coupling between the integrated circuit and the antenna.

6. - The method according to either claim 5 or 6, **characterised in that** the second conductive plates (7a, 7b) are arranged on or at a PVC support.

7. - The method of connecting a chip to an antenna according to claim 5, **characterised in that** the chip is connected to ISO contacts arranged on a side of the substrate (2) opposite to the side of the substrate receiving the first conductive plates (3).

**FIG.1**

**FIG.2A**

FIG.2B

FIG.3

FIG.4A

FIG.4B

FIG.5

FIG.6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2894714
- WO 2009115673 A

- FR 2905494 A1
- FR 2780848 A1